(19) Europäisches Patentamt
European Patent Office
Office européen des brevets

(11) Veröffentlichungsnummer : **0 078 981**
**B1**

(12) # EUROPÄISCHE PATENTSCHRIFT

(45) Veröffentlichungstag der Patentschrift : **07.05.86**

(51) Int. Cl.⁴ : **G 03 F 7/08**, G 03 F 7/02

(21) Anmeldenummer : **82109911.6**

(22) Anmeldetag : **27.10.82**

(54) **Lichtempfindliches Gemisch und daraus hergestelltes lichtempfindliches Kopiermaterial.**

(30) Priorität : **09.11.81 DE 3144499**

(43) Veröffentlichungstag der Anmeldung : **18.05.83 Patentblatt 83/20**

(45) Bekanntmachung des Hinweises auf die Patenterteilung : **07.05.86 Patentblatt 86/19**

(84) Benannte Vertragsstaaten : **DE FR GB NL**

(56) Entgegenhaltungen :
**EP-A- 0 001 254**
**EP-A- 0 022 571**
**DE-A- 2 331 377**
**US-A- 4 101 323**

(73) Patentinhaber : **HOECHST AKTIENGESELLSCHAFT**
**Postfach 80 03 20**
**D-6230 Frankfurt am Main 80 (DE)**

(72) Erfinder : **Stahlhofen, Paul, Dr.**
**Leibnizstrasse 18/B**
**D-6200 Wiesbaden (DE)**

**EP 0 078 981 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein lichtempfindliches, durch Belichten löslich werdendes Gemisch aus

a) einem 1,2-Chinondiazid oder einem Gemisch aus

$a^1$) einer bei Belichtung eine Säure bildenden Verbindung und

$a^2$) einer Verbindung mit mindestens einer durch Säure spaltbaren C—O—C-Bindung,

b) einem wasserunlöslichen, in wäßrig-alkalischen Lösungen löslichen Bindemittel,

c) einer bei Belichtung eine Säure bildenden organischen Verbindung und

d) einem Farbstoff,

das nach der Belichtung einen deutlich sichtbaren Farbkontrast zwischen belichteten und unbelichteten Bereichen aufweist.

Gemische der angegebenen Gattung werden vorzugsweise zur Herstellung von Flachdruckplatten und Photoresists verwendet und sind z. B. aus der DE-OS 23 31 377 bekannt. Die dort beschriebenen Gemische enthalten als Farbstoff (d) einen Triphenylmethan-, Azin- oder Anthrachinonfarbstoff und als säurebildende organische Verbindung ein 1,2-Naphthochinon-2-diazid-4-sulfonsäurehalogenid. Sie ergeben nach der Bildbelichtung einen Bildkontrast, der bei Tageslicht oder bei weißem Kunstlicht gut sichtbar ist. Er ist jedoch unter gelbem Sicherheitslicht, wie es beim Arbeiten mit reprographischen Materialien gewöhnlich verwendet wird, weniger ausgeprägt und in manchen Fällen nicht ausreichend.

In der DE-OS 22 29 365 werden entsprechende Gemische beschrieben, die als Farbstoffe bestimmte Azofarbstoffe und als Säurespender Diazoniumsalze starker Säuren enthalten. Diese Gemische ergeben bei Normallicht und bei Sicherheitslicht nur einen verhältnismäßig geringen visuellen Kontrast.

In den DE-OS 26 41 099 und 28 43 069 sind ähnliche Gemische beschrieben, die als Säurespender Diazoniumsalze und als Farbstoffe Azo-, Triphenylmethan-, Azin- oder Anthrachinonfarbstoffe enthalten. Auch ihr Kontrast ist bei gelbem Sicherheitslicht häufig nicht ausreichend.

In der DE-OS 26 41 100 sind entsprechende Gemische beschrieben, die als Säurespender Trihalogenmethyl-s-triazine oder Trihalogenmethyl-2-pyrone und als Farbstoffe Azin-, Triphenylmethan- oder Anthrachinonfarbstoffe enthalten. Ihr Verhalten ist ähnlich wie das der vorstehend genannten Gemische.

In der DE-OS 29 44 237 werben solche Gemische beschrieben, die als Säurespender 1,2-Naphthochinon-2-diazid-4-sulfonsäureester oder -amide von Phenolen bzw. aromatischen Aminen enthalten, die Elektronen anziehende Substituenten im Benzolkern aufweisen. Bevorzugte Substituenten sind Halogenatome und Nitrogruppen. Als Farbstoffe werden Triphenylmethanfarbstoffe und öllösliche Farbstoffe genannt. Diese Gemische ergeben Farbkontraste, die unter gelbem Licht besser erkennbar sind als bei einigen der zuvor genannten Gemische, doch wird der Kontrast noch nicht allen Anforderungen gerecht.

Der Erfindung liegt die Aufgabe zugrunde, ein positiv arbeitendes lichtempfindliches Gemisch der eingangs beschriebenen Gattung zur Verfügung zu stellen, das nach bildmäßigem Belichten ein Abbild der Vorlage zeigt, das unter gelbem Sicherheitslicht besser zu erkennen ist als bei den bekannten Gemischen.

Gegenstand der Erfindung ist ein lichtempfindliches Gemisch aus

a) einem 1,2-Chinondiazid oder einem Gemisch aus

$a^1$) einer bei Belichtung eine Säure bildenden Verbindung und

$a^2$) einer Verbindung mit mindestens einer durch Säure spaltbaren C—O—C-Bindung,

b) einem wasserunlöslichen, in wäßrig-alkalischen Lösungen löslichen Bindemittel,

c) einer bei Belichtung eine Säure bidenden organischen Verbindung und

d) einem Farbstoff.

Das erfindungsgemäße Gemisch ist dadurch gekennzeichnet, daß der Farbstoff ein Azofarbstoff mit mindestens einer Nitrogruppe im Molekül und die bei Belichtung eine Säure bildende Verbindung (c) ein Ester der allgemeinen Formel I

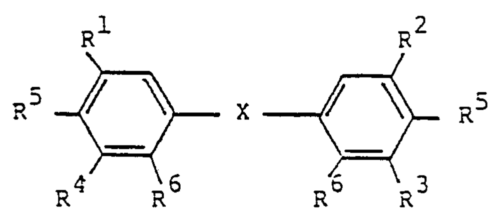

(I)

ist, worin

X eine einfache Bindung oder eine der Gruppen CO, $SO_2$, N=N oder $CR^7R^8$,

$R^1$, $R^2$, $R^3$ und $R^4$ Wasserstoff- oder Halogenatome oder Nitrogruppen, wobei nicht mehr als zwei dieser Reste Wasserstoffatome sind und mindestens einer eine Nitrogruppe ist,

$R^5$ und $R^6$ Wasserstoffatome oder 1,2-Naphthochinon-2-diazid-4-sulfonyloxyreste, wobei $R^5$ und $R^6$ stets voneinander verschieden sind, und

$R^7$ und $R^8$ Wasserstoffatome oder niedere Alkylreste bedeuten.

Die in dem Gemisch enthaltenen Azofarbstoffe enthalten mindestens eine, bevorzugt 2 oder mehrere Nitrogruppen im Molekül. Bevorzugt werden Monoazofarbstoffe, insbesondere solche aus substituierten Benzoldiazoniumverbindungen und aromatischen Aminen als Kupplungskomponenten. Die Azofarbstoffe können außer Nitrogruppen weitere Substituenten enthalten. Beispiele für bevorzugte Substituenten sind : Aminogruppen, besonders tertiäre Aminogruppen, Halogenatome, Alkoxygruppen und Acylaminogruppen. Wegen ihres besonders günstigen Farbkontrastes werden allgemein blaue Azofarbstoffe bevorzugt. Die Menge des Azofarbstoffs beträgt im allgemeinen 0,5 bis 10, vorzugsweise 2 bis 7 Gew.-%, bezogen auf die nichtflüchtigen Bestandteile des Gemischs.

Von den photolytischen Säurespendern der Formel I werden diejenigen bevorzugt, in denen alle Reste $R^1$ bis $R^4$ Halogenatome oder Nitrogruppen sind. Besonders wirksam sind die Verbindungen mit mindestens zwei, insbesondere die mit vier Nitrogruppen im Molekül. Als Halogenatome werden C1 und Br, besonders Br, bevorzugt. Die Reste $R^7$ und $R^8$ haben im allgemeinen 1 bis 4, bevorzugt 1 oder 2 Kohlenstoffatome, wenn sie Alkylreste sind.

Die Verbindungen der Formel I werden analog zu bekannten Naphthochinondiazidsulfonsäureestern durch Umsetzen von reaktiven Sulfonsäurederivaten, z. B. von Sulfonylchloriden, mit den entsprechenden substituierten Bisphenolen hergestellt. Die Säurespender werden im allgemeinen in Mengen von 1 bis 20, vorzugsweise von 7 bis 15 Gew.-%, bezogen auf die nichtflüchtigen Bestandteile, zugesetzt. Die erfindungsgemäßen Gemische sind in Form lichtempfindlicher, auf einen Schichtträger aufgebrachter Schichten oder als Lösungen für die Herstellung von Photoresistschichten über längere Zeiträume im Dunkeln ohne Zersetzung lagerfähig. Der mit ihnen erreichte Bildkontrast ist wesentlich brillanter, als er mit den bekannten Säurespendern in Kombination mit Triphenylmethan-, Azin- oder Anthrachinonfarbstoffen oder mit Azofarbstoffen erzielt wird, die keine Nitrogruppen enthalten.

Das erfindungsgemäße Gemisch enthält als weiteren wesentlichen Bestandteil eine lichtempfindliche Verbindung (a) bzw. eine lichtempfindliche Kombination von Verbindungen ($a^1$ + $a^2$), deren Löslichkeit in einer wäßrig-alkalischen Entwicklerlösung beim Belichten erhöht wird. Hierzu gehören vor allem o-Chinondiazide und Kombinationen von photolytischen Säurespendern mit säurespaltbaren Verbindungen.

Als o-Chinondiazide werden bevorzugt Naphthochinon-(1,2)-diazid-(2)-4- oder -5-sulfonsäureester oder -amide verwendet. Von diesen werden die Ester, insbesondere die der 5-Sulfonsäuren, besonders bevorzugt. Geeignete Verbindungen dieser Art sind bekannt und z. B. in der DE-PS 938 233, den DE-OS 23 31 377, 25 47 905 und 28 28 037 beschrieben.

Die Menge an o-Chinondiazidverbindungen einschließlich der Verbindungen der Formel I beträgt im allgemeinen 3 bis 50, bevorzugt 7 bis 35 Gew.-%, bezogen auf die nichtflüchtigen Anteile des Gemischs.

Auch Materialien auf Basis säurespaltbarer Verbindungen lassen sich mit gutem Effekt in dem erfindungsgemäßen Gemisch einsetzen.

Kopiermaterialien dieser Art sind bekannt und z. B. in den US-PS 3 779 778 und 4 101 323, der DE-PS 27 18 254 und den DE-OS 28 29 512, 28 29 511 und 29 28 636 beschrieben. Sie enthalten als säurespaltbare Verbindungen Orthocarbonsäurederivate, monomere oder polymere Acetale, Enolether oder Acyliminocarbonate, wobei die Orthocarbonsäurederivate und Acetale bevorzugt werden. Als strahlungsempfindliche, Säure abspaltende Verbindungen enthalten sie vorwiegend organische Halogenverbindungen, insbesondere durch Halogenmethylgruppen substituierte s-Triazine. Für diesen Zweck sind grundsätzlich auch Verbindungen der Formel I geeignet.

Von den in der US-PS 4 101 323 beschriebenen Orthocarbonsäurederivaten werden insbesondere die Diphenoxymethylether aliphatischer oder aromatischer Hydroxyverbindungen, die N-Diphenoxymethylderivate von Lactamen sowie ganz besonders die Bis-1,3-dioxan-2-yl-ether von aliphatischen Diolen verwendet.

Von den in der DE-PS 27 18 254 beschriebenen Polyacetalen werden diejenigen mit aliphatischen Aldehyd- und Dioleinheiten bevorzugt.

Von den in der DE-OS 29 28 636 beschriebenen polymeren Orthoestern werden Polymere mit wiederkehrenden 1,3-Dioxa-cyclohex-2-yl-alkylethereinheiten besonders bevorzugt, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 60, vorzugsweise zwischen 14 und 40 Gew.-%, bezogen auf die nichtflüchtigen Bestandteile des Gemischs. Die Menge der damit kombinierten Säure abspaltenden Verbindung liegt zwischen 0,1 und 10, vorzugsweise zwischen 0,2 und 5 Gew.-%.

Die erfindungsgemäßen lichtempfindlichen Gemische enthalten bevorzugt ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemäßen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Als weitere alkalilösliche bzw. in Alkali quellbare Bindemittel sind natürliche Harze, wie Schellack und Kolophonium, und synthetische

Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein ; bevorzugt werden Anteile am Gesamtfeststoff zwischen 95 und 35, besonders bevorzugt 90-55 Gew.-%. Zusätzlich können noch zahlreiche andere Harze mitverwendet werden, bevorzugt Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordenisse wie Flexibilität, Haftung, Glanz und Färbung, außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformanid enthalten können. Prinzipiell sind alle Lösungsmittel verwendbar, die mit den Schichtkomponenten nicht irreversibel reagieren. Partialether von Glykolen, insbesondere Ethylenglykolmonoethylether, werden besonders bevorzugt.

Als Schichtträger für Schichtdicken unter ca. 10 µm werden meist Metalle verwendet. Für Offsetdruckplatten können eingesetzt werden : walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann, außerdem Mehrmetallplatten z. B. aus Al/Cu/Cr oder aus Messing/Chrom. Für die Herstellung von Hochdruckplatten können die erfindungsgemäßen Gemische auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruckoder Siebdruckformen eignen sich die erfindungsgemäßen Gemische durch ihre gute Haftung und Ätzfestigkeit auf Kupfer- und Nickeloberflächen. Ebenso lassen sich die erfindungsgemäßen Gemische als Photoresists in der Leiterplattenfertigung und beim Formteilätzen verwenden. Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transerschichten dienen. Dafür werden Polyesterfolien, z. B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Schließlich kann die Beschichtung von z. B. Leiterplaten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Laserstrahlen stellt eine Möglichkeit zur Bebilderung dar.

Die zum Entwickeln verwendeten wäßrig-alkalischen Lösungen abgestufter Alkalität, vorzugsweise mit einem pH im Bereich von 10-14, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung von Druckformen, d. h. insbesondere Offset-, autotypischen Tiefdruck- und Siebdruckformen, in Photoresistlösungen und sogenannten Trockenresists.

Die Erfindung wird an Hand der folgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1

Mit einer Lösung von

1,00 Gt des Veresterungsproduktes aus 1 Mol 2,3,4-Trihydroxybenzophenon und 3 Mol Naphthochinon- (1,2)-diazid-(2)-5-sulfonsäurechlorid,

6,20 Gt eines Kresol-Formaldehyd-Novolaks mit einem Erweichungspunkt von 120-135 °C und einem durchschnittlichen Molgewicht von 1 500,

1,00 Gt des Veresterungsproduktes aus 1 Mol 2,2'-Dihydroxy-3,5,3',5'-tetranitro-dipenylmethan und 2 Mol Naphthochinon-(1,2)-diazid-(2)-4-sulfonsäurechlorid und

0,40 Gt eines blauen Azofarbstoffs, der durch Kuppeln von 2,4-Dinitro-6-chlor-benzoldiazoniumsalz mit 2-Methoxy-5-acetylamino-N,N-diethylanilin erhalten wurde, in

40 Gt Ethylenglykolmonomethylether und

50 Gt Tetrahydrofuran

wurde eine elektrochemisch aufgerauhte und anodisierte Aluminiumplatte beschichtet. Der anodisierte Träger war vor dem Aufbringen der lichtempfindlichen Kopierschicht mit einer 0,5 %igen wäßrigen Lösung von Polyvinylphosphonsäure behandelt worden. Das Gewicht der trockenen lichtempfindlichen Schicht betrug 2,30 g/$m^2$.

Das so hergestellte vorsensibilisierte Material wurde unter einer transparenten Positiv-Vorlage bildmäßig belichtet.

Während die unbelichteten Bereiche der Kopierschicht tief dukelblau gefärbt blieben, schlug die Farbe der belichteten Bereiche der Schicht nach gelb bis hellbraun um. Man sieht daher das Abbild der Vorlage in so gutem Kontrast, daß es auch bei gelber Beleuchtung in allen Einzelheiten deutlich erkennbar ist.

Zur Herstellung der Druckform wurde bie belichtete Druckplatte in bekannter Weise mit einer 7,3 %igen wäßrigen Natriummetasilikat-Lösung entwickelt, wobei die belichteten Bereiche entfernt wurden. Die zurückbleibenden nicht belichteten Schichtbereiche waren mit gutem Kontrast zum ungefärbten Untergrund sichtbar.

In den folgenden Beispielen 2 bis 7 wurde in entsprechender Weise wie im obigen Beispiel 1 verfahren, und es wurde nach dem Belichten der erhaltenen lichtempfindlichen Druckplatten hinsichtlich Bildkontrast — sowohl vor als auch nach dem Entwickeln — im wesentlichen entspechende gute Resultate erhalten. Es werden daher für die folgenden Beispiele meist nur die Rezepturen der Beschichtungslösungen und die Art der verwendeten Schichtträger angegeben und nur gelegentlich weitere kurze Bemerkungen hinzugefügt.

## Beispiel 2

Beschichtungslösung :

1,00 Gt des Veresterungsproduktes aus 1 Mol 2,3,4-Trihydroxybenzophenon und 3 Mol Naphthochinon- (1,2)-diazid-(2)-5-sulfonsäurechlorid,

6,20 Gt des in Beispiel 1 angegebenen Novolaks,

1,00 Gt des Veresterungsproduktes aus 1 Mol 4,4′-Dihydroxy-3,5,3′,5′-tetranitro-diphenylmethan und 2 Mol Naphthochinon-(1,2)-diazid-(2)-4-sulfonsäurechlorid,

0,30 Gt eines Azofarbstoffes, der durch Kuppeln von 2,4-Dinitro-6-chlor-benzoldiazoniumsalz mit 2-Methoxy-5-acetylamino-N-cyanoethyl-N-hydroxyethyl-anilin erhalten wurde,

40 Gt Ethylenglykolmonomethylether

50 Gt Tetrahydrofuran

Kopierschichtträger : Elektrochemisch aufgerauhte und anodisierte Aluminiumplatte entsprechend Beispiel 1.

Farbumschlag der belichteten Bereiche von tief dunkelblau nach gelbbraun.

## Beispiel 3

Beschichtungslösung :

0,70 Gt des Veresterungsproduktes aus 1 Mol 2,3,4-Trihydroxybenzophenon und 2 Mol Naphthochinon-(1,2)-diazid-(2)-5-sulfonsäurehclorid,

0,60 Gt des Veresterungsproduktes aus 1 Mol 2,2′-Dihydroxy-dinaphthyl-(1,1′)-methan und 2 Mol Naphthochinon-(1,2)-diazid-(2)-5-sulfonsäurechlorid,

5,80 Gt des in Beispiel 1 angegebenen Novolaks,

1,00 Gt des Veresterungsproduktes aus 1 Mol 4,4′-Dihydroxy-3,3′-dinitro-5,5′-dibrom-benzophenon und 2 Mol Naphthochinon-(1,2)-diazid-(2)-4-sulfonsäurechlorid,

0,4 Gt des in Beispiel 1 angegebenen Azofarbstoffs,

40 Gt Ethylenglykolmonomethylether,

50 Gt Tetrahydrofuran.

Schichtträger : Elektrochemisch aufgerauhte und anodisierte Aluminiumplatte entsprechend Beispiel 1.

Farbumschlag der belichteten Bereiche von tief dunkelblau nach gelbbraun.

Beispiel 4

Beschichtungslösung :

0,70 Gt des Veresterungsproduktes aus 1 Mol 2,3,4-Trihydroxy-benzophenon und 2 Mol Naphthochinon-(1,2)-diazid-(2)-5-sulfonsäurechlorid,
0,40 Gt des Veresterungsproduktes aus 1 Mol 2,2'-Dihydroxy-dinaphtyl-(1,1')-methan und 2 Mol Naphthochinon-(1,2)-diazid-(2)-5-sulfonsäurechlorid,
6,00 Gt des in Beispiel 1 angegebenen Novolaks,
1,00 Gt des Veresterungsproduktes aus 1 Mol 3,3'-Dibrom-4,4'-dihydroxy-5,5'-dinitro-azobenzol und 2 Mol Naphtochinon-(1,2)-diazid-(2)-4-sulfonsäurechlorid,
0,30 Gt des in Beispiel 2 angegebenen blauen Azofarbstoffs,
40 Gt Ethylenglykolmonomethylether,
50 Gt Tetrahydrofuran.

Kopierschichtträger : Elektrochemisch aufgerauhte und anodisierte Aluminiumplatte entsprechend Beispiel 1.
Farbumschlag der belichteten Bereiche von tief dunkelblau nach hellbraun.

Beispiel 5

Beschichtungslösung :

0,70 Gt des Veresterungsproduktes aus 1 Mol 2,3,4-Trihydroxy-benzophenon und 2 Mol Naphthochinon-(1,2)-diazid-(2)-5-sulfonsäurechlorid,
0,40 Gt des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid,
5,80 Gt des in Beispiel 1 angegebenen Novolaks,
1,00 Gt des Veresterungsproduktes aus 1 Mol 4,4'-Dihydroxy-3,5,3',5'-tetranitro-diphenylsulfon und 2 Mol Naphthochinon-(1,2)-diazid-(2)-4-sulfonsäurechlorid,
0,30 Gt des in Beispiel 1 angegebenen Azofarbstoffes,
40 Gt Ethylenglykolmonomethylether,
50 Gt Tetrahydrofuran.

Kopierschichtträger : Elektrochemisch aufgerauhte und anodisierte Aluminiumplatte entsprechend Beispiel 1.
Farbumschlag von tief dunkelblau nach braun.

Beispiel 6

Beschichtungslösung :

1,00 Gt des Veresterungsproduktes aus 1 Mol 2,3,4-Trihydroxybenzophenon und 3 Mol Naphthochinon-(1,2)-diazid-(2)-5-sulfonsäurechlorid,
6,40 Gt des in Beispiel 1 angegebenen Novolaks,
0,90 Gt des Veresterungsproduktes aus 1 Mol 2,2'-Dihydroxy-3,5,3',5'-tetranitro-diphenylmethan und 2 Mol Naphthochinon-(1,2)-diazid-(2)-4-sulfonsäurechlorid,
0,30 Gt eines Azofarbstoffes, der durch Kuppeln von 4-Nitro-benzoldiazoniumsalz mit Diphenylamin erhalten wurde,
40 Gt Ethylenglykolmonomethylether,
50 Gt Tetrahydrofuran.

Kopierschichträger : Elektrochemisch aufgerauhte und anodisierte Aluminiumplatte entsprechend Beispiel 1.
Farbumschlag der belichteten Bereiche von rotbraun nach schwarz.

Beispiel 7

Beischichtungslösung :

0,70 Gt des Veresterungsproduktes aus 1 Mol 2,3,4-Trihydroxy-benzophenon und 2 Mol Naphthochinon-(1,2)-diazid-(2)-5-sulfonsäurechlorid,
0,40 Gt des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid,
5,80 Gt des in Beispiel 1 angegebenen Novolaks,

0,90 Gt des Veresterungsproduktes aus 1 Mol 4,4'-Dihydroxy-3,5,3',5'-tetranitro-diphenyl und 2 Mol Naphthochinon-(1,2)-diasid-(2)-4-sulfonsäurechlorid,
0,30 Gt des in Beispiel 1 angegebenen Azofarbstoffes;
40 Gt Ethylenglykolmonomethylether,
50 Gt Tetrahydrofuran.

Kopierschichtträger : Elektrochemisch aufgerauhte und anodisierte Aluminiumplatte entsprechend Beispiel 1.
Farbumschlag der belichteten Bereiche von blau nach braun.

Beispiel 8

Beschichtungslösung :

1,2 Gt einer 50 %igen Lösung eines Polyorthoesters in Toluol, hergestellt aus 7,7-Bis-hydroxymethyl-5-oxa-nonanol-(1) und Orthoameisensäuretrimethylester,
0,3 Gt des Veresterungsproduktes aus 1 Mol 2,2'-Dihydroxy-3,5,3',5'-tetranitro-diphenylmethan und 2 Mol Naphthochinon-(1,2)-diazid-(2)-4-sulfonsäurechlorid,
1,0 Gt des in Beispiel 1 angegebenen Novolaks,
0,1 Gt des in Beispiel 1 angegebenen blauen Azofarbstoffs.
20,0 Gt Ethylenglykolmonomethylether,
20,0 Gt Tetrahydrofuran.

Schichtträger : Elektrochemisch aufgerauhte und anodisierte Aluminiumplatte.
Farbumschlag der belichteten Bereiche von dunkelblau nach gelbbraun.

Beispiel 9

Beschichtungslösung :

0,6 Gt eines Polyacetals, hergestellt aus Triethylenglykol und 2-Ethyl-butyraldehyd,
0,3 Gt des Veresterungsproduktes aus 1 Mol 4,4'-Dihydroxy-3,5,3',5'-tetranitro-diphenylmethan und 2 Mol Naphthochinon-(1,2)-diazid-(2)-4-sulfonsäurechlorid,
1,0 Gt des in Beispiel 1 angegebenen Novolaks,
0,1 Gt des in Beispiel 1 angegebenen Azofarbstoffs.
20,0 Gt Ethylenglykolmonomethylether,
20,0 Gt Tetrahydrofuran.

Schichtträger : Elektrochemisch aufgerauhte und anodisierte Aluminiumplatte.
Farbumschlag der belichteten Bereiche von blau nach hellbraun.

**Patentansprüche**

1. Lichtempfindliches Gemisch aus
   a) einem 1,2-Chinondiazid oder einem Gemisch aus
      a[1]) einer bei Belichtung eine Säure bildenden Verbindung und
      a[2]) einer Verbindung mit mindestens einer durch Säure spaltbaren C—O—C-Bindung,
   b) einem wasserunlöslichen, in wäßrig-alkalischen Lösungen löslichen Bindemittel,
   c) einer bei Belichtung eine Säure bildenden organischen Verbindung und
   d) einem Farbstoff

dadurch gekennzeichnet, daß der Farbstoff ein Azofarbstoff mit mindestens einer Nitrogruppe im Molekül und die bei Belichtung eine Säure bildende Verbindung (c) ein Ester der allgemeinen Formel I

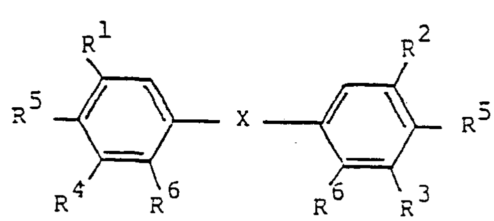

(I)

ist, worin
X eine einfache Bindung oder eine der Gruppen CO, $SO_2$, N=N oder $CR^7R^8$,
$R^1$, $R^2$, $R^3$ und $R^4$ Wasserstoff- oder Halogenatome oder Nitrogruppen, wovon nicht mehr als zwei Wasserstoffatome sind und mindestens einer eine Nitrogruppe ist,

$R^5$ und $R^6$ Wasserstoffatome oder 1,2-Naphthochinon-2-diazid-4-sulfonyloxyreste, wobei $R^5$ und $R^6$ stets voneinander verschieden sind, und

$R^7$ und $R^8$ Wasserstoffatome oder niedere Alkylreste bedeuten.

2. Lichtempfindliches Gemisch nach Anspruch 1, dadurch gekennzeichnet, daß die Reste $R^1$ bis $R^4$ Halogenatome oder Nitrogruppen sind.

3. Lichtempfindliches Gemisch nach Anspruch 1, dadurch gekennzeichnet, daß mindestens zwei der Reste $R^1$ bis $R^4$ Nitrogruppen sind.

4. Lichtempfindliches Gemisch nach Anspruch 1, dadurch gekennzeichnet, daß es einen Monoazofarbstoff enthält.

5. Lichtempfindliches Gemisch nach Anspruch 1, dadurch gekennzeichnet, daß es 0,5 bis 10 Gew.-% an Azofarbstoff, bezogen auf seinen Gehalt an nichtflüchtigen Bestandteilen, enthält.

6. Lichtempfindliches Gemisch nach Anspruch 1, dadurch gekennzeichnet, daß es als Bindemittel einen Novolak enthält.

7. Lichtempfindliches Gemisch nach Anspruch 1, dadurch gekennzeichnet, daß es als 1,2-Chinondiazid einen 1,2-Naphthochinon-2-diazid-sulfonsäureester enthält.

8. Lichtempfindliches Gemisch nach Anspruch 1, dadurch gekennzeichnet, daß es als Verbindung mit mindestens einer durch Säure spaltbaren C—O—C-Bindung ein Orthocarbonsäurederivat oder eine Verbindung mit mindestens einer Acetalgruppe im Molekül enthält.

9. Lichtempfindliches Kopiermaterial aus einem Schichtträger und einer lichtempfindlichen Schicht, die bei Belichtung in einem Entwickler löslich wird, und die als wesentliche Bestandteile

a) ein 1,2-Chinondiazid oder ein Gemisch aus
   - a[1]) einer bei Belichtung eine Säure bildenden Verbindung und
   - a[2]) einer Verbindung mit mindestens einer durch Säure spaltbaren C—O—C-Bindung,

b) ein wasserunlösliches, in wäßrig-alkalischen Lösungen lösliches Bindemittel,

c) eine bei Belichtung eine Säure bildende organische Halogenverbindung und

d) einen Farbstoff

enthält, dadurch gekennzeichnet, daß der Farbstoff ein Azofarbstoff mit mindestens einer Nitrogruppe im Molekül und die bei Belichtung eine Säure bildende Verbindung (c) ein Ester der allgemeinen Formel I

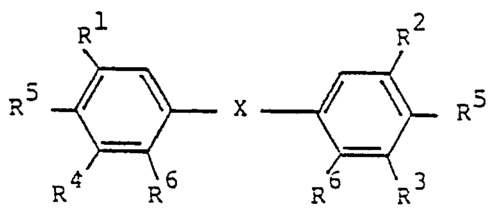

(I)

ist, worin

X eine einfache Bindung oder eine der Gruppen CO, $SO_2$, N=N oder $CR^7R^8$,

$R^1$, $R^2$, $R^3$ und $R^4$ Wasserstoff- oder Halogenatome oder Nitrogruppen, wovon nicht mehr als zwei Wasserstoffatome sind und mindestens einer eine Nitrogruppe ist,

$R^5$ und $R^6$ Wasserstoffatome oder 1,2-Naphthochinon-2-diazid-4-sulfonyloxyreste, wobei $R^5$ und $R^6$ stets voneinander verschieden sind, und

$R^7$ und $R^8$ Wasserstoffatome oder niedere Alkylreste bedeuten.

**Claims**

1. A light-sensitive mixture of

a) a 1,2-quinonediazide or a mixture of
   - a[1]) a compound forming an acid on exposure and
   - a[2]) a compound having at least one C—O—C bond cleavable by acid,

b) a water-insoluble binder soluble in aqueous-alkaline solutions,

c) an organic compound forming an acid on exposure and

d) a dyestuff,

wherein the dyestuff is an azo dyestuff containing at least one nitro group in the molecule and the compound (c) forming an acid on exposure is an ester of the general formula I

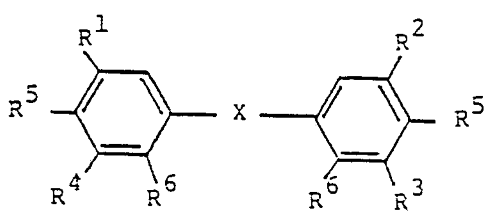

(I)

in which

X is a single bond or one of the groups CO, $SO_2$, N=N or $CR^7R^8$,

$R^1$, $R^2$, $R^3$ and $R^4$ are hydrogen atoms or halogen atoms or nitro groups, with not more than two of these radicals being hydrogen atoms and at least one thereof being a nitro group,

$R^5$ and $R^6$ are hydrogen atoms or 1,2-naphthoquinone-2-diazide-4-sulfonyloxy radicals, with $R^5$ and $R^6$ being always different from each other, and

$R^7$ and $R^8$ are hydrogen atoms or lower alkyl radicals.

2. A light-sensitive mixture as claimed in claim 1, wherein the radicals $R^1$ to $R^4$ are halogen atoms or nitro groups.

3. A light-sensitive mixture as claimed in claim 1, wherein at least 2 of the radicals $R^1$ to $R^4$ are nitro groups.

4. A light-sensitive mixture as claimed in claim 1, which contains a monoazo dyestuff.

5. A light-sensitive mixture as claimed in claim 1, which contains 0.5 to 10 % by weight of azo dyestuff, relative to its content of nonvolatile constituents.

6. A light-sensitive mixture as claimed in claim 1, which contains a novolak as the binder.

7. A light-sensitive mixture as claimed in claim 1, which contains a 1,2-naphthoquinone-2-diazidesulfonic acid ester as the 1,2-quinonediazide.

8. A light-sensitive mixture as claimed in claim 1, which contains an orthocarboxylic acid derivative or a compound having at least one acetal group in the molecule as the compound having at least one C—O—C bond cleavable by acid.

9. A light-sensitive copying material made of a support and a light-sensitive layer which becomes soluble in a developer on exposure and contains as essential constituents

a) a 1,2-quinonediazide or a mixture of

a[1]) a compound forming an acid on exposure and

a[2]) a compound having at least one C—O—C bond cleavable by acid,

b) a water-insoluble binder soluble in aqueous-alkaline solutions,

c) an organic halogen compound forming an acid on exposure and

d) a dyestuff,

wherein the dyestuff is an azo dyestuff containing at least one nitro group in the molecule and the compound (c) forming an acid on exposure is an ester of the general formula I

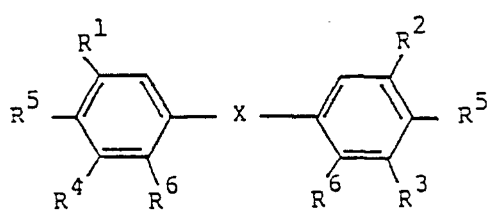

(I)

in which

X is a single bond or one of the groups CO, $SO_2$, N=N or $CR^7R^8$,

$R^1$, $R^2$, $R^3$ and $R^4$ are hydrogen atoms or halogen atoms or nitro groups, with not more than two of these radicals being hydrogen atoms and at least one thereof being a nitro group,

$R^5$ and $R^6$ are hydrogen atoms or 1,2-naphthoquinone-2-diazide-4-sulfonyloxy radicals, with $R^5$ and $R^6$ being always different from each other, and

$R^7$ and $R^8$ are hydrogen atoms or lower alkyl radicals.

**Revendications**

1. Mélange photosensible, composé de :

a) un 1,2-quinonediazide ou un mélange de :

a[1]) un composé formant un acide par exposition et

a[2]) un composé ayant au moins une liaison C—O—C scindable par un acide,

b) un liant insoluble dans l'eau, soluble dans des solutions aqueuses-alcalines,

c) un composé organique formant un acide par exposition et

d) un colorant

caractérisé en ce que le colorant est un colorant azoïque avec au moins un groupe nitro dans la molécule et le composé (c) formant un acide par exposition est un ester de formule générale I

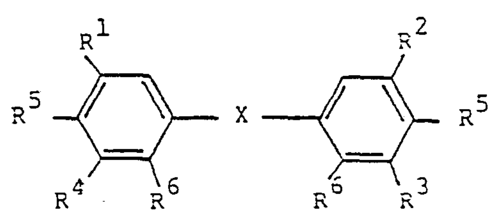

(I)

dans laquelle :

X est une simple liaison ou un des groupes CO, $SO_2$, N=N ou $CR^7R^8$,

$R^1$, $R^2$, $R^3$ et $R^4$ représentent des atomes d'hydrogène ou d'halogène ou des groupes nitro, dont deux au maximum sont des atomes d'hydrogène et un au moins est un groupe nitro,

$R^5$ et $R^6$ représentent des atomes d'hydrogène ou un groupe 1,2-naphtoquinone-2-diazide-4-sulfonyloxy, $R^5$ et $R^6$ étant toujours différents l'un de l'autre, et

$R^7$ et $R^8$ représentent des atomes d'hydrogène ou des groupes alkyle inférieur.

2. Mélange photosensible selon la revendication 1, caractérisé en ce que les groupes $R^1$ à $R^4$ sont des atomes d'halogène ou des groupes nitro.

3. Mélange photosensible selon la revendication 1, caractérisé en ce qu'au moins deux des groupes $R^1$ à $R^4$ sont des groupes nitro.

4. Mélange photosensible selon la revendication 1, caractérisé en ce qu'il contient un colorant monoazoïque.

5. Mélange photosensible selon la revendication 1, caractérisé en ce qu'il contient de 0,5 à 10 % en poids d'un colorant azoïque, par rapport au poids de constituants non volatils dans le mélange.

6. Mélange photosensible selon la revendication 1, caractérisé en ce qu'il contient une novolaque en tant que liant.

7. Mélange photosensible selon la revendication 1, caractérisé en ce qu'il contient un ester d'acide 1,2-naphtoquinone-2-diazide-sulfonique en tant que 1,2-quinonediazide.

8. Mélange photosensible selon la revendication 1, caractérisé en ce qu'il contient un dérivé d'acide orthocarboxylique ou un composé ayant au moins un groupe acétal en tant que composé avec au moins une liaison C—O—C scindable par un acide.

9. Matériau à copier photosensible composé d'un support de couche et d'une couche photosensible, soluble dans un agent de développement par exposition, et qui contient comme constituants essentiels :

a) un 1,2-quinonediazide ou un mélange de :

a¹) un composé formant un acide par exposition et

a²) un composé ayant au moins une liaison C—O—C scindable par un acide,

b) un liant insoluble dans l'eau, soluble dans des solutions aqueuses-alcalines,

c) un composé halogéné organique formant un acide par exposition, et

d) un colorant,

caractérisé en ce que le colorant est un colorant azoïque ayant au moins un groupe nitro dans la molécule et le composé (c) formant un acide par exposition est un ester de formule générale I

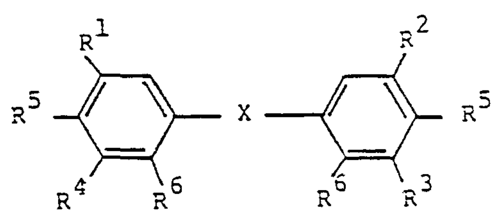

(I)

dans laquelle

X est une simple liaison ou un des groupes CO, $SO_2$, N=N ou $CR^7R^8$,

$R^1$, $R^2$, $R^3$ et $R^4$ représentent des atomes d'hydrogène ou d'halogène ou des groupes nitro, dont deux au plus sont des atomes d'hydrogène et au moins un est un groupe nitro,

$R^5$ et $R^6$ représentent des atomes d'hydrogène ou des groupes 1,2-naphtoquinone-2-diazide-4-sulfonyloxy, $R^5$ et $R^6$ étant toujours différents l'un de l'autre, et

$R^7$ et $R^8$ représentent des atomes d'hydrogène ou des groupes alkyle inférieur.